Europäisches Patentamt

European Patent Office

Office européen des brevets

(11) Veröffentlichungsnummer: **0 150 362**
**A2**

(19)

(12) # EUROPÄISCHE PATENTANMELDUNG

(21) Anmeldenummer: 84115056.8

(51) Int. Cl.⁴: **H 05 K  1/03**

(22) Anmeldetag: **10.12.84**

(30) Priorität: **27.01.84 DE 3402883**

(43) Veröffentlichungstag der Anmeldung: **07.08.85**
**Patentblatt 85/32**

(84) Benannte Vertragsstaaten: **AT BE CH DE FR GB IT LI NL SE**

(71) Anmelder: **Siemens Aktiengesellschaft, Berlin und München Wittelsbacherplatz 2, D-8000 München 2 (DE)**

(72) Erfinder: **von Gentzkow, Wolfgang, Dr.,
Zwetschgenweg 1, D-8524 Kleinsendelbach (DE)**
Erfinder: **Hdl, Maximilian, Dr., Neubibergerstrasse 14,
D-8000 Mnchen 83 (DE)**
Erfinder: **Kleeberg, Wolfgang, Dr., Hessenstrasse 7,
D-8520 Erlangen (DE)**
Erfinder: **Markert, Helmut, Dr., Lohengrinstrasse 17,
D-8500 Nrnberg (DE)**

(54) **Leiterplatten aus Schichtpressstoffen.**

(57) Erhöht funktionstüchtige Leiterplatten aus Schichtpreß-stoffen mit Epoxidharz als Bindemittel enthalten – zur Inhi-bierung der Kupferwanderung – 0,1 bis 10 Masse-% N,N′-Bis-salicyloyl-hydrazin, bezogen auf das gehärtete Epoxid-harz.

EP 0 150 362 A2

SIEMENS AKTIENGESELLSCHAFT   Unser Zeichen
Berlin und München          VPA 84 P 3017 E

_1_

Leiterplatten aus Schichtpreßstoffen

Die Erfindung betrifft Leiterplatten aus Schichtpreßstoffen mit Epoxidharz als Bindemittel sowie ein Verfahren zur Herstellung derartiger Leiterplatten.

Leiterplatten, insbesondere mehrlagige Leiterplatten,
sind die tragenden Basiselemente für die Verschaltung
von aktiven und passiven Bauteilen (siehe: G. Herrmann
"Handbuch der Leiterplattentechnik", 2. Auflage,
Eugen G. Leuze Verlag, 1982). Die Funktionstüchtigkeit
der Leiterplatten ist somit ein entscheidender Faktor
für die Qualität und die Zuverlässigkeit elektronischer
Schaltungen und Baugruppen.

Es ist aber zu beobachten, daß die Funktionstüchtigkeit
von Leiterplatten der genannten Art durch einen als
Kupferwanderung bezeichneten Prozeß beeinträchtigt
wird. Bei diesem Prozeß bilden sich - innerhalb relativ
kurzer Zeiträume - insbesondere zwischen Durchkontaktierung und Potentiallage Kupferbrücken aus, welche zum
Kurzschluß führen und damit zum Ausfall der entsprechenden Baugruppe. Diese Kupferbrücken werden auch als
"Conductive Anodic Filaments" (CAF) bezeichnet.

Zur Untersuchung des Prozesses der Kupferwanderung
wurden Labormethoden entwickelt, um die Ausbildung der
Filamente zeitraffend zu prüfen und damit die Ursachen
für diesen Vorgang zu finden und somit die CAF-Anfälligkeit verschiedener Harzsysteme beurteilen zu können.
Im allgemeinen werden dabei Prüfkörper bei erhöhter

Bh 2 Koe / 24.1.1984

Temperatur und erhöhter Luftfeuchtigkeit mit einer Prüfspannung von ca. 100 V beaufschlagt. Bei den heute überwiegend eingesetzten Leiterplatten auf der Basis von glasfaserverstärkten Epoxidharzen, beispielsweise der Klassifizierung FR-4, führen diese Bedingungen bereits nach wenigen Tagen zu ersten Ausfällen.

In der Praxis werden derart beschädigte Leiterplatten selten repariert, da die Kurzschlußbrücken nur schwer zu orten sind. Vielmehr wird in den meisten Fällen die gesamte Baugruppe ausgetauscht, was im allgemeinen mit nicht unerheblichen Kosten verbunden ist. Der Inhibierung der Kupferwanderung bei Leiterplatten kommt somit, insbesondere mit zunehmender Miniaturisierung und erhöhter Packungsdichte, eine wachsende Bedeutung zu, vor allem auch hinsichtlich des Einsatzes in Feuchträumen bei erhöhter Temperatur, beispielsweise in feuchtwarmen Klimazonen.

Das Problem der Kupferwanderung bei Leiterplattenmaterialien aus Epoxid-Glashartgeweben, d.h. bei Leiterplatten aus glasfaserverstärkten Epoxidharzen, ist seit Jahren bekannt. Versuche zur Lösung dieses Problems konzentrieren sich bis heute auf das Auffinden und die Erprobung CAF-resistenter Harzsysteme. Dabei wurde beispielsweise die Verwendung von Reaktionsharzen auf der Basis von Triazinen, Bismaleinimid-triazinen (sogenannte BT-Harze) und Polyimiden anstelle von Epoxidharzen vorgeschlagen (siehe: J.P. Mitchell, T.L. Welsher in "Proceedings of the Printed Circuit World Convention II", Volume 1, Seiten 80 bis 93, Eugen G. Leuze Verlag, 1981). Alle Systeme mit guter CAF-Resistenz, wie beispielsweise die Polyimide, haben aber den Nachteil, daß sie wesentlich teurer sind als Epoxidharze. Da mit verbesserter Halbleitertechnik die Bauteilkosten sinken und damit der Anteil der Leiterplatten an den Gesamtkosten der Baugruppen ohnehin im Steigen begriffen ist, ist
der Einsatz von Harzen der genannten Art aber keine
wirtschaftliche Lösung des Problems der Kupferwanderung.

Aufgabe der Erfindung ist es, qualitativ hochwertige
und kostengünstige Leiterplatten auf der Basis von
Schichtpreßstoffen mit Epoxidharzen als Bindemittel zu
schaffen, welche eine ausreichende CAF-Resistenz besitzen.

Dies wird erfindungsgemäß dadurch erreicht, daß die
Leiterplatten 0,1 bis 10 Masse-% N.N'-Bis-salicyloyl-
hydrazin enthalten, bezogen auf das gehärtete Epoxidharz.

Vorzugsweise enthalten die Leiterplatten 0,5 bis
5 Masse-% N.N'-Bis-salicyloyl-hydrazin, im folgenden
auch kurz BSH genannt. Der BSH-Gehalt ist dabei auf das
gehärtete Epoxidharz bezogen, d.h. auf das Epoxidharz
einschließlich Härter und gegebenenfalls Beschleuniger.

N.N'-Bis-salicyloyl-hydrazin ist zwar als Metalldesaktivator für mit Kupfer in Berührung stehende Polymere
bekannt (siehe beispielsweise DE-PS 27 03 558). Es ist
aber durchaus überraschend und es war nicht absehbar,
daß die Kupferwanderung in Leiterplatten aus Schichtpreßstoffen, insbesondere aus Epoxid-Glashartgeweben,
durch BSH wirkungsvoll inhibiert werden kann. Die Vorgänge der Kupferkatalyse bei der thermisch-oxidativen
Alterung von Polymeren, insbesondere Polyolefinen, und
der Kupferwanderung in Leiterplatten unterscheiden sich
nämlich grundlegend voneinander. Im Falle der Kupferkatalyse bilden sich durch Oxidation von Kupferoberflächen Kupferionen, welche in Form von Carboxylaten in
das Polymere hineindiffundieren können. In den Grenzschichten zum Kupfer können sich dann im Polymeren – innerhalb relativ langer Zeiträume – Kupferkonzentrationen von maximal ca. $10^{-3}$ Mol/kg Polymer anreichern. Da BSH in den Polymeren ungelöst vorliegt und nicht migrationsfähig ist, fängt es die Kupferionen ab und desaktiviert sie durch Komplexbildung. Geht man von den üblicherweise verwendeten Desaktivatorkonzentrationen von 0,3 bis 0,5 % im Polymeren aus, so steht den eindiffundierenden Kupferionen ein mindestens 20- bis 40facher Überschuß an Komplexbildner gegenüber.

Ganz anders verhält es sich beim Vorgang der Kupferwanderung in Leiterplatten. Hier bilden sich nämlich innerhalb relativ kurzer Zeit (einige $10^2$ h) massive Kupferfilamente aus. Bei eigenen Versuchen wurden so beispielsweise Filamente mit einer Länge von 275 µm und einem Durchmesser von 10 bis 50 µm gefunden. Bei der Bildung dieser Filamente werden in einem sehr geringen Volumen relativ große Kupfermengen nach einem bislang unbekannten Mechanismus transportiert (beispielsweise in einem Volumen von $2 \times 10^{-6}$ cm$^3$ bis zu 20 µg Kupfer). Auf diesem Transportweg befindet sich Kupfer in Konzentrationen, die mindestens $10^3$ mal größer sind als die Konzentration des BSH. Bei einer mittleren BSH-Konzentration von etwa 1 % in der Harzmatrix müßte dann der Inhibitor, d.h. das BSH, aus dem 2000fachen Volumen herandiffundieren, um das bei der Kupferwanderung transportierte Kupfer zu binden. Bei der verschwindend geringen Löslichkeit von BSH in Epoxidharzen ist dies ein sehr unwahrscheinlicher Vorgang. Es muß deshalb davon ausgegangen werden, daß die Grenzfläche zwischen Kupfer und Epoxidharz inaktiviert wird, d.h. auf der Kupferoberfläche werden Sperrschichten aufgebaut, und daß die bei der Herstellung der durchkontaktierten Leiterplatten entstandenen Kupferionen während des Herstellungsprozesses gebunden werden.

Die Herstellung von Leiterplatten erfolgt im allgemeinen in der Weise, daß ein Fasermaterial, das zur Verstärkung dient, mit einer Harzlösung getränkt wird und die dabei erhaltenen Prepregs zu Schichtpreßstoffen weiterverarbeitet werden. Bei der Herstellung der erfindungsgemäßen Leiterplatten wird dabei einer Epoxidharzlösung N.N'-Bis-salicyloyl-hydrazin zugesetzt. Als Epoxidharze eignen sich dabei aliphatische, cycloaliphatische und aromatische Epoxide sowie deren Mischungen. Vorzugsweise werden dabei Epoxidharze auf der Basis von Bisphenol-A-diglycidylether, Bisphenol-F-diglycidylether sowie Polydiglycidylether von Phenol/Formaldehyd- bzw. Kresol/Formaldehyd-Novolak eingesetzt. Weitere einsetzbare Epoxidharze sind beispielsweise 3.4-Epoxycyclohexylmethyl-3'.4'-epoxycyclohexancarboxylat, Diglycidylester von Phthal-, Isophthal- und Terephthalsäure sowie Gemische dieser Ester, hydrierte Bisphenol-A- bzw. Bisphenol-F-diglycidylether, Triglycidylisocyanurat, Triglycidyl-p-aminophenol, Tetraglycidyldiaminodiphenylmethan und Tetraglycidyldiaminodiphenylether sowie weitere Epoxide, die im "Handbook of Epoxy Resins" von Henry Lee und Kris Neville, McGraw-Hill Book Company, 1967, und in der Monographie von Henry Lee "Epoxy Resins", American Chemical Society, 1970, beschrieben sind. Die Epoxidharze werden mit Härtungsmitteln, wie beispielsweise Dicyandiamid, gegebenenfalls unter Verwendung von basisch wirkenden Härtungskatalysatoren (Beschleunigern), wie beispielsweise Dimethylbenzylamin, gehärtet, d.h. in sogenannte Epoxidharzformstoffe übergeführt.

Als verstärkendes Material finden in den erfindungsgemäßen Leiterplatten vorzugsweise Glasfasern Verwendung, insbesondere in Form von Geweben oder Vliesen. Daneben können beispielsweise aber auch Gewebe oder Vliese aus Cellulosefasern eingesetzt werden.

Anhand von Ausführungsbeispielen soll die Erfindung noch näher erläutert werden.

96 g eines zu 16 % kernbromierten Bisphenol-A-diglycidyletherharzes, 3,9 g Dicyandiamid und 0,2 g Dimethylbenzylamin werden in einem Gemisch aus 40 ml Cyclohexanon und 50 ml Dimethylformamid gelöst. Zu dieser Epoxidharzlösung werden unterschiedliche Mengen an Inhibitor (siehe die nachfolgende Tabelle) in feinteiliger Form (mittlere Teilchengröße: 1 µm) zugegeben und durch intensives Rühren sowie mit Hilfe von Ultraschall dispergiert bzw. gelöst. Durch diese Harzlösung wird in einer Imprägnierapparatur ein Glasfasergewebe (US Style 2116, 30 cm breit) mit einer Geschwindigkeit von 0,4 m/min gezogen und das beschichtete Glasfasergewebe in einem Trockenturm bei Temperaturen bis zu 160°C lösungsmittelfrei getrocknet. Die Dicke des beschichteten Glasfasergewebes (Prepreg) beträgt ca. 0,1 mm.

Das beschichtete Glasfasergewebe wird in Stücke mit einer Länge von je 40 cm geschnitten. Je zehn dieser Stücke werden in Stapeln zwischen je zwei 35 µm dicken Kupferfolien, wie sie für die Leiterplattenherstellung verwendet werden, von der gleichen Größe (30 cm x 40 cm) angeordnet und unter einem Druck bis zu 25 bar und bei Temperaturen bis zu 180°C zu beidseitig kupferkaschierten Platten einer Dicke von ca. 1 mm verpreßt; hierbei erfolgt auch die Härtung des Epoxidharzes. Nach dem Strukturieren der Kupferflächen mit Hilfe der Photo- und Ätztechnik wird auf die als innere Lage vorgesehene strukturierte Kupferfläche ein Stapel aus vier Prepregs und einer weiteren Kupferfolie unter gleichen Bedingungen aufgepreßt; die dabei erhaltene neue Kupferfläche wird ebenfalls strukturiert. Dann werden die Bohrungen erzeugt und durchkontaktiert (Lochmetallisierung mittels Kupfer), so daß Probekörper entstehen, deren Prüfstellen zwischen der jeweiligen Lochmetallisierung und der inneren Potentiallage einen definierten Prüfabstand von 275 µm aufweisen. Die Probekörper werden durch Stanzen in eine Größe von 110 mm x 40 mm gebracht. Jeder Prüfkörper enthält 40 Prüfstellen.

Zur Prüfung werden die Prüfkörper kontaktiert und in einem Klimaschrank bei 90°C und 75 % relativer Feuchte mit einer Spannung von 100 V beaufschlagt. Gemessen wird jeweils der Isolationswiderstand zwischen Lochmetallisierung und innerer Potentiallage. Prüfstellen, an denen der Widerstand vom anfänglichen, im Prüfklima gemessenen Wert auf Werte $\leq 10^5 \Omega$ abgesunken ist, gelten als ausgefallen. Durch Anfertigung von Schliffen kann an diesen Prüfstellen die Ausbildung von Kupferfilamenten nachgewiesen werden.

In der Tabelle sind die Ergebnisse zusammengestellt, die an inhibitorfreien Prüfkörpern sowie an Inhibitor enthaltenden Prüfkörpern erhalten wurden. Als Inhibitor dient BSH in verschiedenen Konzentrationen sowie - zum Vergleich - N-Salicyloyl-N'-salicyliden-hydrazin. Der Tabelle ist zu entnehmen, daß die erfindungsgemäßen Leiterplatten Leiterplatten ohne BSH und auch Leiterplatten, welche einen an sich bekannten Komplexbildner enthalten, beträchtlich überlegen sind.

0150362

| Inhibitor | Zahl der Prüfstellen | Zahl der Ausfälle nach 150 h | 500 h | 1000 h |
|---|---|---|---|---|
| ohne | 320 | 2 | 78 | 212 |
| 1 % N-Salicyloyl-N'-salicyli-den-hydrazin | 320 | 3 | 84 | 228 |
| 0,5 % N,N'-Bis-salicyloyl-hydrazin | 320 | 0 | 0 | 0 |
| 1 % " | 320 | 0 | 0 | 0 |
| 5 % " | 320 | 0 | 0 | 0 |
| 10 % " | 320 | 0 | 0 | 0 |

Sowohl an den Leiterplatten ohne Inhibitor als auch an denjenigen mit BSH als Inhibitor wurden die für Leiterplatten üblichen Prüfungen nach DIN 40802 bzw. IEC 249 durchgeführt, wie beispielsweise die Prüfung des Oberflächenwiderstandes, des Durchgangswiderstandes, des Verlustfaktors bei 1 MHz, der Dielektrizitätszahl und der Lötbadbeständigkeit. Die dabei erhaltenen Meßwerte entsprachen in allen Fällen den Anforderungen, d.h. auch bei den Inhibitor enthaltenden Leiterplatten.

5 Patentansprüche

<u>Patentansprüche</u>

1. Leiterplatten aus Schichtpreßstoffen mit Epoxidharz als Bindemittel, d a d u r c h  g e k e n n - z e i c h n e t ,  daß sie 0,1 bis 10 Masse-% N.N'-Bis-salicyloyl-hydrazin enthalten, bezogen auf das gehärtete Epoxidharz.

2. Leiterplatten nach Anspruch 1,  g e k e n n - z e i c h n e t  durch einen Gehalt von 0,5 bis 5 Masse-% N.N'-Bis-salicyloyl-hydrazin.

3. Leiterplatten nach Anspruch 1 oder 2, d a d u r c h  g e k e n n z e i c h n e t ,  daß sie Glasfasergewebe oder -vliese enthalten.

4. Verfahren zur Herstellung von Leiterplatten nach einem der Ansprüche 1 bis 3,  d a d u r c h  g e k e n n z e i c h n e t ,  daß der zur Prepregher-stellung verwendeten Epoxidharzlösung N.N'-Bis-salicyloyl-hydrazin zugesetzt wird.

5. Verfahren nach Anspruch 4,  d a d u r c h  g e -k e n n z e i c h n e t ,  daß als Epoxidharze Bisphenol-A-diglycidylether, Bisphenol-F-diglycidylether oder Polydiglycidylether von Phenol/Formaldehyd- oder Kresol/Formaldehyd-Novolak verwendet werden.